Europäisches Patentamt

European Patent Office

Office européen des brevets

(11) Veröffentlichungsnummer: **0 258 564**
**A2**

(12) # EUROPÄISCHE PATENTANMELDUNG

(21) Anmeldenummer: 87109379.5

(22) Anmeldetag: 30.06.87

(51) Int. Cl.⁴: **H05K 3/22**

(30) Priorität: 29.08.86 DE 3629887

(43) Veröffentlichungstag der Anmeldung:
**09.03.88 Patentblatt 88/10**

(84) Benannte Vertragsstaaten:
**AT BE CH DE ES FR GB GR IT LI LU NL SE**

(71) Anmelder: **Deutsche Telephonwerke und
Kabelindustrie Aktiengesellschaft
Wrangelstrasse 100
D-1000 Berlin 36(DE)**

(72) Erfinder: **de Boer, Reinhard
Birnhornweg 19
D-1000 Berlin 42(DE)**

(54) **Verfahren zum Herstellen von Leiterplatten.**

(57) Die Erfindung beschreibt ein Verfahren zum Herstellen von Leiterplatten, die schwarzverchromte Leiterbahnen mit galvanisch aufgeschmolzenen Zinn-Blei-Lötaugen aufweisen, wobei die Sicherheit der Kontaktstellen von Zinn-Blei zum Schwarzchrom auch nach dem Ätzprozeß gewährleistet ist.

EP 0 258 564 A2

## Verfahren zur Herstellung von Leiterplatten

Die Erfindung betrifft ein Verfahren zur Herstellung von Leiterplatten, die schwarzverchromte Leiterbahnen mit galvanisch aufgeschmolzenen Zinn-Blei-Lötaugen aufweisen.

Es ist bekannt, durchkontaktierte und durch Kupfer verstärkte, bedruckte Leiterplatten mit einer Schwarz-Chrom-Schicht zu überziehen, die als Ätzschutz beim späteren Ätzen des Kupfers dient. Eine Schwarz-Chrom-Schicht bietet außerden den Vorteil guter Korrosions-und Temperaturbeständigkeit der durch sie geschützten Leiterzüge gegenüber üblicher galvanischer Zinn-Blei-Beschichtung. Um eine gute Lötbarkeit der Lötaugen zu erreichen, wird die bisher relativ aufwendige Heißverzinnung angewendet.

Der Erfindung liegt die Aufgabe zugrunde, ein Verfahren für Leiterplatten zu schaffen, das - schwarzverchromte Leiterbahnen mit galvanisch aufgeschmolzenen Zinn-Blei-Lötaugen kombiniert und dabei die Kontaktstellen zwischen Zinn-Blei und Schwarz-Chrom im nachfolgenden Ätzprozeß nicht angegriffen bzw. durchgeätzt werden.

Diese Aufgabe ist durch die Erfindung gelöst, wie sie im Kennzeichnungsteil des Patentanspruches dargelegt ist.

Das Verfahren beruht auf der Anwendung von alkalischwässrigen Fotoresisten, z. B. einer einprozentigen Sodalösung zur Entwicklung der über eine Fotovorlage mittels UV-Licht belichteten Leiterplatten. Diese Fotoresiste weisen eine hohe Galvanofestigkeit auf, eine sehr gute Haftung auf Kupfer und eine gute Chemikalienfestigkeit, z. B. gegen das Zinn-Blei-Strippen.

Für die Herstellung von Leiterplatten nach dem vorgeschlagenen Verfahren werden zunächst die bekannten Arbeitsgänge von der Filmherstellung über die Basismaterialbehandlung und dem chemischen Aufbringen des Kupfers ausgeführt. Nach einem Reinigen wird der Fotoresist laminiert, das Schaltbild belichtet, entwickelt und schließlich galvanisch Kupfer sowie Zinn-Blei-Schichten auf die Leiterplatte gebracht.

Abweichend von dem bekannten Verfahren werden nunmehr erfindungsgemäß die Leiterplatten gewaschen und getrocknet. Erneut wird ein Fotoresist laminiert. Danach wird die Leiterplatte mit Ausnahme der Leiterbahnen belichtet und anschließend der Fotoresist entwickelt. Es folgt das Strippen der Zinn-Blei-Schicht, wobei die nicht abgedeckten Zinn-Blei-Schichten abgelöst werden. Anschließend wird eine chemische Reinigung durch Sprühen oder Tauchen vorgenommen. Damit ist die Leiterplatte für das nachfolgende galvanische Schwarzverchromen vorbereitet.

Nach dem Schwarzverchromen werden die bekannten Verfahrensstufen vom Strippen des Fotoresist über das Ätzen, Aufhellen und Trocknen, dem Laminieren des Lötstopp-Fest-oder Flüssig-Resist bis zum Aufschmelzen der Lotschicht angewendet.

Bei diesem Verfahren sind die galvanischen Kontaktstellen zwischen den Zinn-Blei-Lötaugen und den schwarzverchromten Leitern so sicher, daß sie im Ätzprozeß weder angegriffen noch durchgeätzt werden.

## Ansprüche

Verfahren zur Herstellung von Leiterplatten, die schwarzverchromte Leiterbahnen mit galvanisch aufgeschmolzenen Zinn-Blei-Lötaugen aufweisen, unter Verwendung von alkalisch-wässrigen Fotoresisten, wobei mittels Fotovorlagen und UV-lichtempfindlichen Fotoresisten diē Leiterzüge erstellt und anschließend galvanisch die Kupfer-und Zinn-Bleischichten darauf abgeschieden werden, dadurch gekennzeichnet, daß nach der Beendigung der galvanischen Verfahrensstufen die folgenden Schritte ausgeführt werden:

a) Waschen und Trocknen der Leiterplatten,

b) Laminieren einer zweiten Fotoresistschicht,

c) Belichten der Leiterplatte mit Ausnahme der Leiterbahnen,

d) Entwickeln des Fotoresists,

e) Strippen der Zinn-Bleischicht der Leiterbahnen,

f) chemische Vorreinigung,

g) Schwarzverchromung,

h) konventionelle Weiterverarbeitung in bekannten Verfahrensschritten vom Strippen des Fotoresists bis zum Umschmelzen.